# EUROPEAN PATENT APPLICATION

(11) **EP 3 778 436 A1**
(43) Date of publication of application: **17.02.2021**
(21) Application number: 19786134.7
(22) Date of filing: 14.02.2019
(51) Int. Cl.: B65G 1/04, G05D 1/02

(54) **TRANSPORT VEHICLE SYSTEM AND TRANSPORT VEHICLE CONTROL METHOD**

(30) Priority: 12.04.2018 JP 2018076903
(71) Applicant: Murata Machinery, Ltd., Kyoto-shi, Kyoto 601-8326 (JP)
(72) Inventor: KITAMURA, Wataru, Inuyama-shi, Aichi 484-8502 (JP)
(74) Representative: Stöckeler, Ferdinand
(86) International application number: PCT/JP2019/005330
(87) International publication number: WO 2019/198330

(57) **Abstract**

[Problem] To efficiently execute a plurality of pickup requests or prevent delay in execution of a high-priority pickup request.

[Means to Solve Problem] A transport vehicle system comprising: a plurality of transport vehicles V which travel on a track T; and a controller 110 which performs an assignment process such that upon receiving a plurality of pickup requests, a transport vehicle V expected to arrive sooner at a pickup point ST is selected from the plurality of transport vehicles V in a descending order of priorities of the plurality of pickup requests, and a pickup instruction which instructs to travel to the pickup point ST arranged along the track T and pick up an article M at the pickup point ST is assigned to each one of the plurality of transport vehicles V, wherein the controller 110 cancels the pickup instruction previously assigned to each of the plurality of transport vehicles V and assigns a pickup instruction thereto again by the assignment process, when a change in an expected arrival order of the plurality of transport vehicles V traveling toward the pickup points ST in accordance with the pickup instructions or a change in priorities of the pickup requests is recognized.

## Description

### Technical Field

The present invention relates to a transport vehicle system and a transport vehicle control method.

### Background Art

In a semiconductor device manufacturing factory or the like, a transport vehicle system for controlling a plurality of transport vehicles which transport articles is used. Upon receiving a plurality of pickup requests, a controller of the transport vehicle system assigns each of the plurality of transport vehicles able to perform a pickup operation with a pickup instruction which causes each transport vehicle to travel to a pickup point and pick up an article at the pickup point. The pickup requests received by the controller may be given priorities in an order of articles which need to be transported promptly. The controller is required to execute a high-priority pickup request promptly. Patent Literature 1 below discloses that in a case where after pickup instructions have been assigned, there emerges a transport vehicle to which a new pickup instruction can be assigned upon completing the transport of an article in accordance with another pickup instruction, the assignment of the pickup instruction, which has already been assigned to a transport vehicle and the article transport for which has not been completed, is revised.

### Citation List

### Patent Literature

[Patent Literature 1] Japanese Unexamined Patent Application, First Publication No. 2002-006951

### Summary of Invention

### Technical Problem

As mentioned above, the processing of the transport vehicle system disclosed in Patent Literature 1 starts in the case where after pickup instructions have been assigned, there emerges a transport vehicle to which a new pickup instruction can be assigned, and therefore, pickup instructions will not be assigned again unless a transport vehicle to which a pickup instruction can be assigned is present under the management of the controller. The plurality of transport vehicles travel on a track installed on a ceiling or a floor, however, the transport vehicles may not reach pickup points at expected timings, depending on the traveling status of each transport vehicle. In such a case, even if the arrival order of the transport vehicles at a pickup point changes, the pickup instructions which have already been assigned are still executed as they are unless there is a transport vehicle to which a pickup instruction can be assigned. As a result, a plurality of pickup requests may not be executed efficiently in some cases. For example, there may be a situation where a pickup request which is supposed be executed first is forced to be executed after the execution of another pickup request. Even in a case where a high-priority pickup request newly emerges after pickup instructions have been assigned, since the pickup instructions which have already been assigned are still executed as they are, the execution of the high-priority pickup request may be delayed.

It is an object of the present invention is to provide a transport vehicle system and a transport vehicle control method each able to efficiently excecute a plurality of pickup requests or to avoid delay in the execution of a high-priority pickup request by assigning again pickup instructions to a plurality of transport vehicles.

### Means for Solving Problem

A transport vehicle system of the present invention is a transport vehicle system comprising: a plurality of transport vehicles which travel on a track; and a controller which performs an assignment process such that upon receiving a plurality of pickup requests, a transport vehicle expected to arrive sooner at a pickup point is selected from the transport vehicles in a descending order of priorities of the plurality of pickup requests, and a pickup instruction which instructs to travel to the pickup point arranged along the track and pick up an article at the pickup point is assigned to each one of the plurality of transport vehicles, wherein the controller cancels the pickup instruction previously assigned to each of the plurality of transport vehicles and assigns a pickup instruction thereto again by the assignment process, when a change in an expected arrival order of the plurality of transport vehicles traveling toward the pickup points in accordance with the pickup instructions or a change in priorities of the pickup requests is recognized.

The controller may determine whether or not the priorities of the pickup requests have changed, at a timing when a pickup request with a priority higher than that of the pickup request in any of the previously assigned pickup instructions newly emerges. The track may include a merging part where a branch track merges into a main track, at least two of the pickup points may be arranged on the main track ahead of the merging part, and the controller may determine, at a timing when a preceding transport vehicle among the plurality of transport vehicles passes through the merging part, whether the expected arrival order of the plurality of transport vehicles has changed in a case where the actual passing order of the transport vehicles differs from that expected. The track may include a branching part where a branch track branches off from a main track, the pickup point may be arranged on the main track ahead of the branching part and on the branch track, and the controller may determine, at a timing when a preceding transport vehicle among the plurality of transport vehicles passes through the branching part, whether the expected arrival order of the plurality of transport vehicles has changed in a case where the actual passing order of the transport vehicles differs from that expected.

The controller may determine, at a timing of determining a delay of a predetermined amount of time in any of the transport vehicles traveling toward the pickup point, whether the expected arrival order of the plurality of transport vehicles has changed. In a case where the plurality of transport vehicles are traveling toward the pickup points in accordance with the pickup instructions, the controller may determine, at timings at predetermined time intervals, whether the expected arrival order of the plurality of transport vehicles has changed.

A transport vehicle control method of the present invention is a transport vehicle control method for controlling a plurality of transport vehicles traveling on a track by means of a controller, the controller executing steps of: performing an assignment process such that upon receiving a plurality of pickup requests, a transport vehicle expected to arrive sooner at a pickup point is selected from the plurality of transport vehicles in a descending order of priorities of the plurality of pickup requests, and a pickup instruction which instructs to travel to the pickup point arranged along the track and pick up an article at the pickup point is assigned to each one of the plurality of transport vehicles; and canceling the pickup instruction previously assigned to each of the plurality of transport vehicles and assigning a pickup instruction thereto again by the assignment process, when a change in an expected arrival order of the plurality of transport vehicles traveling toward the pickup points in accordance with the pickup instructions or a change in priorities of the pickup requests is recognized. Advantageous Effects of the Invention

According to the transport vehicle system and the transport vehicle control method of the present invention, pickup instructions are assigned again to the plurality of transport vehicles according to the change in the status of the transport vehicles after the pickup instructions have been assigned, and as a result, a plurality of pickup requests can be executed efficiently by assigning the pickup instruction to the best suited transport vehicle. Also, pickup instructions are assigned again to the plurality of transport vehicles according to the change in the status of the pickup request after the pickup instructions have been assigned, and as a result, delay can be avoided in the execution of a high-priority pickup request.

In the configuration such that the controller determines whether or not the priorities of the pickup requests have changed, at the timing when a pickup request with a priority higher than that of the pickup request in any of the previously assigned pickup instructions newly emerges, delay can be avoided in the execution of the high-priority pickup request by assigning appropriate pickup instructions again when a high-priority pickup request emerges. In the configuration such that the track includes a merging part where a branch track merges into a main track, at least two of the pickup points are arranged on the main track ahead of the merging part, and the controller determines, at a timing when a preceding transport vehicle among the plurality of transport vehicles passes through the merging part, whether the expected arrival order of the plurality of transport vehicles has changed in a case where the actual passing order of the transport vehicles differs from that expected, appropriate pickup instructions can be assigned again by confirming the order of the transport vehicles passing the merging part. In the configuration such that the track includes a branching part where a branch track branches off from a main track, the pickup point is arranged on the main track ahead of the branching part and on the branch track, and the controller determines, at a timing when a preceding transport vehicle among the plurality of transport vehicles passes through the branching part, whether the expected arrival order of the plurality of transport vehicles has changed in a case where the actual passing order of the transport vehicles differs from that expected, since pickup instructions are assigned again at a timing when the preceding transport vehicle passes the branching part, it is possible to avoid a transport vehicle passing through the branching part first from executing a low-priority pickup request first, and it is possible to cause a transport vehicle to execute a high-priority pickup request.

In the configuration such that the controller determines, at a timing of determining a delay of a predetermined amount of time in any of the transport vehicles traveling toward a pickup point, whether the expected arrival order of the plurality of transport vehicles has changed, it is possible to cause, instead of the transport vehicle determined as being delayed, another transport vehicle to efficiently execute the pickup request by assigning pickup instructions again at a timing of determining the delay in the transport vehicle. In the configuration such that in a case where the plurality of transport vehicles are traveling toward the pickup points in accordance with the pickup instructions, the controller determines, at timings at predetermined time intervals, whether the expected arrival order of the plurality of transport vehicles has changed, a change in the expected arrival order of the plurality of transport vehicles is determined periodically and pickup instructions are assigned again, and as a result, a plurality of pickup requests can be efficiently executed.

### Brief Description of the Drawings

Fig. 1 is a diagram showing an example of a transport vehicle system according to an embodiment.
Fig. 2 is a diagram showing an example of a functional block configuration of a controller.
Fig. 3 is a diagram showing an example of an operation sequence in a transport vehicle control method according to the embodiment.
Fig. 4 is a diagram showing an example of an operation flow related to an assignment process.
Fig. 5 is a diagram showing an example of an operation flow in assigning pickup instructions again.
Fig. 6 is a diagram showing an example of an operation of transport vehicles.
Fig. 7 is a diagram, which follows Fig. 6, for describing an operation of the transport vehicles.
Fig. 8 is a diagram, which follows Fig. 7, for describing an operation of the transport vehicles.
Fig. 9 is a diagram showing another example of the operation flow in assigning pickup instructions again.
Fig. 10 is a diagram showing another example of the operation of transport vehicles.
Fig. 11 is a diagram, which follows Fig. 10, for describing the operation of the transport vehicles.
Fig. 12 is a diagram, which follows Fig. 11, for describing the operation of the transport vehicles.
Fig. 13 is a diagram showing another example of the operation flow in assigning pickup instructions again.
Fig. 14 is a diagram showing another example of the operation of transport vehicles.
Fig. 15 is a diagram, which follows Fig. 14, for describing the operation of the transport vehicles.
Fig. 16 is a diagram, which follows Fig. 15, for describing the operation of the transport vehicles.
Fig. 17 is a diagram showing another example of the operation flow in assigning pickup instructions again.
Fig. 18 is a diagram showing another example of the operation flow in assigning pickup instructions again. Description of Embodiments

Hereinafter, an embodiment will be described. However, the invention defined in the claims is not limited to the following embodiment, and not all combinations of features described in the embodiment are essential to the means by which the present invention solves the above problems. In the drawings, scale is changed as necessary to illustrate the embodiment, such as by enlarging or by emphasizing a part.

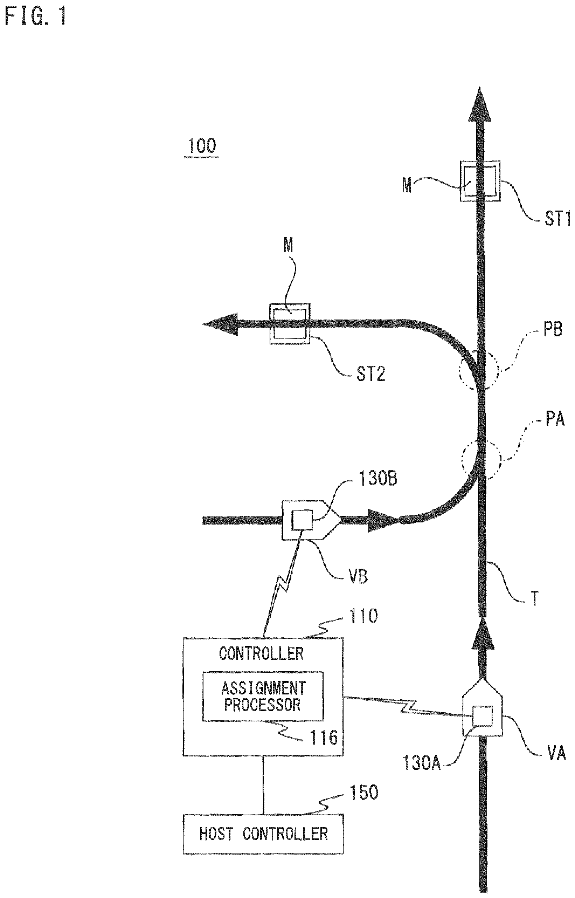

Fig. 1 is a diagram showing an example of a transport vehicle system 100 according to the embodiment. The transport vehicle system 100 includes a plurality of transport vehicles VA, VB (hereunder, may be collectively referred to as transport vehicles V), a controller 110 which controls the plurality of transport vehicles V, an in-vehicle controllers 130A, 130B (hereunder, may be collectively referred to as in-vehicle controllers 130) provided in and controls each transport vehicle V, and a host controller 150. The controller 110 and the in-vehicle controllers 130 are wirelessly connected to communicate with each other via a transmission path such as a wireless LAN (Local Area Network) or a feeder line. The controller 110 and the host controller 150 are connected to communicate with each other via a transmission line such as a wired LAN or a wireless LAN.

The transport vehicle V is, for example, an overhead transport vehicle and travels on a track T. The track T is installed on or near a ceiling of a building. The transport vehicle V includes, for example, a receiving/delivering operator which receives or delivers articles M to stations ST arranged on a floor surface of the building. The transport vehicle V may be in a mode of traveling on a track T installed on the floor. Examples of the stations ST include a load port of a processing apparatus or a stocker.

The transport vehicle V transports the article M placed at a station ST instructed as a pickup point among the plurality of stations ST1, ST2 (hereunder, may be collectively referred to as stations ST) arranged along the track T to a station ST specified as an unloading point. In the following description, the station ST serving as a pickup point of the article M is referred to as a pickup point ST, and the station ST serving as an unloading point of the article M is referred to as an unloading point ST. For example, the station ST1 at the pickup point is referred to as a pickup point ST1, and the station at the unloading point ST2 is referred to as an unloading point ST2.

The track T has a merging point PA which is a point where a plurality of tracks merge, and a branching part PB which is a point where the track T branches into a plurality of tracks. The plurality of vehicles V cannot simultaneously pass through the merging part PA of the track T. Therefore, for example, the transport vehicles V which are about to pass through the merging part PA of the track T each request the controller 110 for a passage permission, and the controller 110 sequentially permits the transport vehicles which each requested for a passage permission to pass the merging part PA.

The controller 110 has an assignment processor 116 which instructs the plurality of transport vehicles V able to perform a pickup to each travel to a pickup point ST, and which assigns the transport vehicles V with pickup instructions to instruct to pick up the article M at the pickup points ST. The controller 110, in accordance with the assignment performed by the assignment processor 116, transmits the pickup instructions to the plurality of transport vehicles V able to perform a pickup. Upon receiving the pickup instruction from the controller 110, the transport vehicles V travel toward the pickup points ST designated by the pickup instructions. In the present embodiment, an example will be described in which a pickup instruction instructs a station ST at a pickup point as well as a station ST at an unloading point. However, the invention is not limited to this example, and as another embodiment, a pickup instruction may instruct a station ST at a pickup point and an unloading instruction may instruct a station ST at an unloading point. In the present embodiment, a case is described where after assigning a pickup instruction to each of the plurality of transport vehicles V, there is no transport vehicle V under the management of the controller 110 to which a pickup instruction can be assigned.

The assignment processor 116 of the controller 110 cancels the pickup instruction previously assigned to each of the plurality of transport vehicles V and assigns a pickup instruction thereto again by an assignment process, when a change in an expected order of arrival at the pickup point ST of the plurality of transport vehicles V traveling toward the pickup points ST in accordance with the pickup instructions or a change in priorities of pickup requests received from the host controller 150 is recognized.

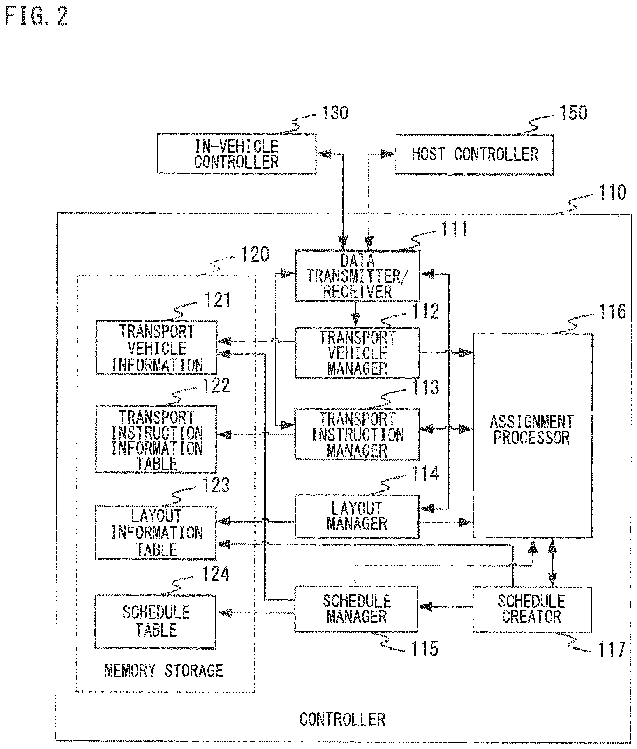

Fig. 2 is a diagram showing an example of a functional block configuration of the controller 110. The controller 110 includes a data transmitter/receiver 111, a transport vehicle manager 112, a transport instruction manager 113, a layout manager 114, a schedule manager 115, an assignment processor 116, a schedule creator 117, and a memory storage 120.

The memory storage 120 stores a transport vehicle information table 121, a transport instruction information table 122, a layout information table 123, and a schedule table 124. The transport vehicle information table 121 includes various types of information related to the transport vehicle V, including position information of the transport vehicle V, and information which indicates a state of the transport vehicle V such as whether the transport vehicle V is in a normal state or in a usable state. The transport instruction information table 122 stores contents of a transport instruction transmitted from the host controller 150 to the controller 110. The layout information table 123 stores map data which indicate layouts of the track T, positions of stations ST, and so forth. The schedule table 124 stores information of the pickup points ST and the unloading points ST, information of schedules of transport vehicles V which travel toward the pickup points ST and the unloading points ST, information of times at which pickups are performed at the pickup point ST, and information which indicates transport schedules of transport vehicles V, including information of times at which unloading is performed at the unloading points ST.

The data transmitter/receiver 111 transmits or receives data to or from the in-vehicle controller 130 and the host controller 150. For example, the data transmitter/receiver 111 transmits a position query, which is a piece of data instructing a transport vehicle V to report position information thereof, to the in-vehicle controller 130. The data transmitter/receiver 111 receives a position information report, which is a piece of data indicating the position information of the transport vehicle V, from the in-vehicle controller 130. The data transmitter/receiver 111 receives a transport instruction, which is a piece of data instructing a pickup point ST and an unloading point ST of an article M, from the host controller 150. The data transmitter/receiver 111 transmits a pickup instruction, which is a piece of data instructing a transport schedule, to the in-vehicle controller 130. The data transmitter/receiver 111 receives a transport completion report, which is a piece of data indicating that transport of an article M has been completed, from the in-vehicle controller 130. The data transmitter/receiver 111 also transmits the transport completion report to the host controller 150.

The transport vehicle manager 112 manages states of transport vehicles V. For example, upon receiving a new position information report, the transport vehicle manager 112 updates the information stored in the transport vehicle information table 121 with the position information of the transport vehicle V reported in the position information report. When an abnormality occurs in a transport vehicle V, the transport vehicle manager 112 notifies the assignment processor 116 to that effect. When the number of usable transport vehicles V increases or decreases, the transport vehicle manager 112 notifies the assignment processor 116 to that effect.

The transport instruction manager 113 manages transport instructions received from the host controller 150. For example, upon receiving a new transport instruction from the host controller 150, the transport instruction manager 113 updates the information stored in the transport instruction information table 122 with the content instructed by the transport instruction. When the transport instruction manager 113 receives a new transport instruction from the host controller 150, the transport instruction manager 113 transmits the transport instruction to the assignment processor 116.

The layout manager 114 manages layouts of the track T, positions of the stations ST, and so forth. For example, when new map data is received from the host controller 150, or when the map data stored in a memory storage medium is modified according to an operation of an administrator, the layout manager 114 updates the information stored in the layout information table 123 with the new map data. When a congestion or the like occurs in a section of the track T, the layout manager 114 notifies the assignment processor 116 to that effect. When a section of the track T is closed, the layout manager 114 notifies the assignment processor 116 to that effect.

The schedule manager 115 manages transport schedules of the transfer vehicles V. For example, when a new transport schedule for a transport vehicle V is created, the schedule manager 115 updates the information stored in the schedule table 124 with the new transport schedule. When a new transport schedule of a transport vehicle V is changed, the schedule manager 115 updates the information stored in the schedule table 124 with the changed transport schedule. The schedule manager 115 makes reference to the position information of the transport vehicle V stored in the transport vehicle information table 121 and the transport schedule of the transport vehicle V stored in the schedule table 124, and in the case where a transport vehicle V traveling toward a pickup point ST is delayed, for example, at the merging part PA or the branching part PB on the track T, by more than a specific amount of time, the schedule manager 115 notifies the assignment processor 116 to that effect.

When at least one of the plurality of transport vehicles V traveling toward pickup points ST passes through the merging part PA or the branching part PB provided on the track T, the assignment processor 116 recognizes a change having occurred in the expected arrival order of the plurality of the transport vehicles V at the pickup point ST if the order of the plurality of transport vehicles V passing through the merging part PA or the branching part PB differs from the order thereof passing through the merging part PA and the branching part PB expected from the previously assigned pickup instructions, and the assignment processor 116 then cancels the pickup instruction previously assigned to each of the plurality of transport vehicles V and assigns a pickup instruction thereto again by means of the assignment process. That is to say, the assignment processor 116 assigns pickup instructions to the plurality of transport vehicles V again at timings when the plurality of transport vehicles V pass through the merging part PA or the branching part PB, so that the order at the merging part PA or the branching part PB corresponds to the transport vehicles V which arrive sooner at the pickup points ST from the merging part PA or the branching part PB. The timing of passing through the merging part PA or the branching part PB may be a timing at which the controller 110 permits a transport vehicle V to pass through the merging part PA or the branching part PB, or may be a timing at which the transport vehicle V is passing or has passed through the merging part PA or the branching part PB.

In a state where a plurality of pickup instructions have already been assigned to the same number of transport vehicles V and there is no transport vehicle V to which no pickup instruction is assigned, upon receiving a new pickup request for an article 2 from the host controller 150, the assignment processor 116 recognizes a change having occurred in the priorities of the pickup requests, at a timing when the priority of the new pickup request is determined as being higher than that of the pickup request in any of the previously assigned pickup instructions, and cancels the pickup instructions previously assigned to the plurality of transport vehicles V traveling toward the pickup points ST in accordance with the previously assigned assignment instructions. Moreover, the assignment processor 116 assigns pickup instructions again by means of the assignment process, including the new pickup request with a high priority.

The assignment processor 116 determines whether or not the transport vehicle V traveling toward a pickup point ST (such as a high-priority pickup point ST) in accordance with a pickup instruction is delayed by more than a specific amount of time. At the timing when the delay is determined, the assignment processor 116 recognizes a change in the expected arrival order of the plurality of transport vehicles V at the pickup point ST, and assigns pickup instructions again to the plurality of transport vehicles V so that the pickup instruction is assigned to the transport vehicle V which is expected to arrive sooner at the pickup point ST.

In the case where the plurality of transport vehicles V are traveling toward the pickup points ST in accordance with the pickup instructions, the assignment processor 116 determines a change in the expected arrival order of the plurality of transport vehicles V at timings at predetermined time intervals, that is, every time a predetermined amount time elapses (at a predetermined cycle). When a change is recognized in the expected arrival order of the of the plurality of transport vehicles V at the pickup point ST, the assignment processor 116 cancels the pickup instruction previously assigned to each of the plurality of transport vehicles V and assigns a pickup instruction thereto again by means of the assignment process. Whether or not the assignment processor 116 cancels the previously assigned pickup instructions and assigns pickup instructions again at the timings of the predetermined time intervals is arbitrary, and the assignment processor 116 may not assign the pickup instructions again.

The schedule creator 117 creates a transport schedule of each transport vehicle V. For example, on the basis of a correspondence relationship between a transport vehicle V and a pickup instruction assigned by the assignment processor 116, the schedule creator 117 creates a transport schedule of the transport vehicle V, making reference to information stored in the layout information table 123.

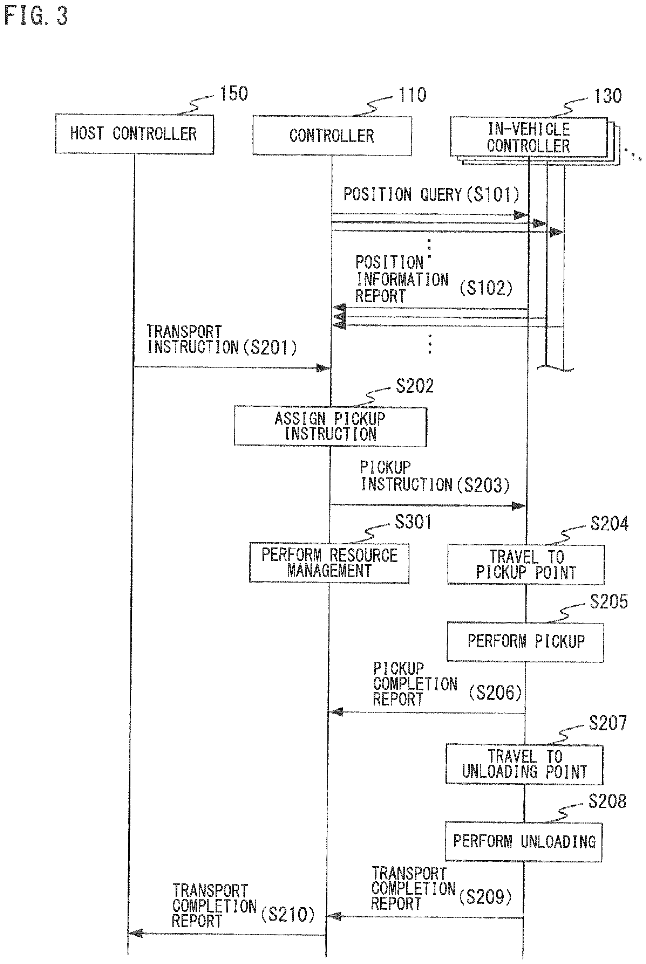

Fig. 3 shows a transport vehicle control method according to the embodiment, and shows an example of an operation sequence related to the processing performed by the controller 110, the in-vehicle controller 130, and the host controller 150. In the description of this operation sequence, reference will be made to Fig. 1 and Fig. 2 where appropriate. The data transmitter/receiver 111 of the controller 110 transmits a position query instructing to report the position information of the transport vehicle V, to the in-vehicle controller 130 of each of the plurality of transport vehicles V at a predetermined cycle (Step S101) .

Upon receiving the position query from the controller 110, the in-vehicle controller 130 transmits to the controller 110 a position information report indicating the position information of the transport vehicle V itself (Step S102). Upon receiving the position information report from the in-vehicle controller 130, the data transmitter/receiver 111 of the controller 110 transmits the position information report to the transport vehicle manager 112. Upon receiving the position information report from the data transmitter/receiver 111, the transport vehicle manager 112 of the controller 110 updates the information stored in the transport vehicle information table 121 with the position information of the transport vehicle V reported in the position information report. According to this configuration, the controller 110 can update the position information of the plurality of transport vehicles V to the latest position information at a predetermined cycle.

Upon receiving from the host controller 150 a transport instruction which instructs a pickup point ST and an unloading point ST of an article M to be transported (Step S201), the data transmitter/receiver 111 of the controller 110 transmits the transport instruction to the assignment processor 116. The transport instruction includes a pickup request to pick up the article M at the pickup point ST. Upon receiving the transport instruction from the data transmitter/receiver 111, the assignment processor 116 instructs each of the plurality of transport vehicles V able to perform pickup to travel to the pickup point ST on the basis of the content of the transport instruction, and assigns a pickup instruction instructing to pick up the article M at the pickup point ST (Step S202). Details of the assignment process in Step S202 will be described later.

The assignment processor 116 transmits the assigned pickup instruction to a target transport vehicle V (Step S203). Upon receiving the pickup instruction from the controller 110, the in-vehicle controller 130 controls the transport vehicle V so as to travel toward the pickup point ST instructed by the pickup instruction (Step S204). Subsequently, upon arrival at the pickup point ST, the in-vehicle controller 130 controls the transport vehicle V so as to pick up the article M at the pickup point ST (Step S205). Upon completion of the pickup of the article M, the in-vehicle controller 130 transmits a pickup completion report to the controller 110. When the vehicle V finishes the pickup, the in-vehicle controller 130 controls the transport vehicle V so as to travel toward the unloading point ST included in the pickup instruction (Step S207).

Subsequently, upon arrival at the unloading point ST, the in-vehicle controller 130 controls the transport vehicle V so as to unload the article M at the unloading point ST (Step S208). When the transport vehicle V finishes the unloading, the in-vehicle controller 130 transmits to the controller 110 a transport completion report, which is a piece of data indicating that the transport of the article M has been completed (Step S209). Upon receiving the transport completion report from the in-vehicle controller 130, the data transmitter/receiver 111 of the controller 110 forwards the transport completion report to the host controller 150 (Step S210). According to this configuration, the articles M can be appropriately transported by the plurality of transport vehicles V.

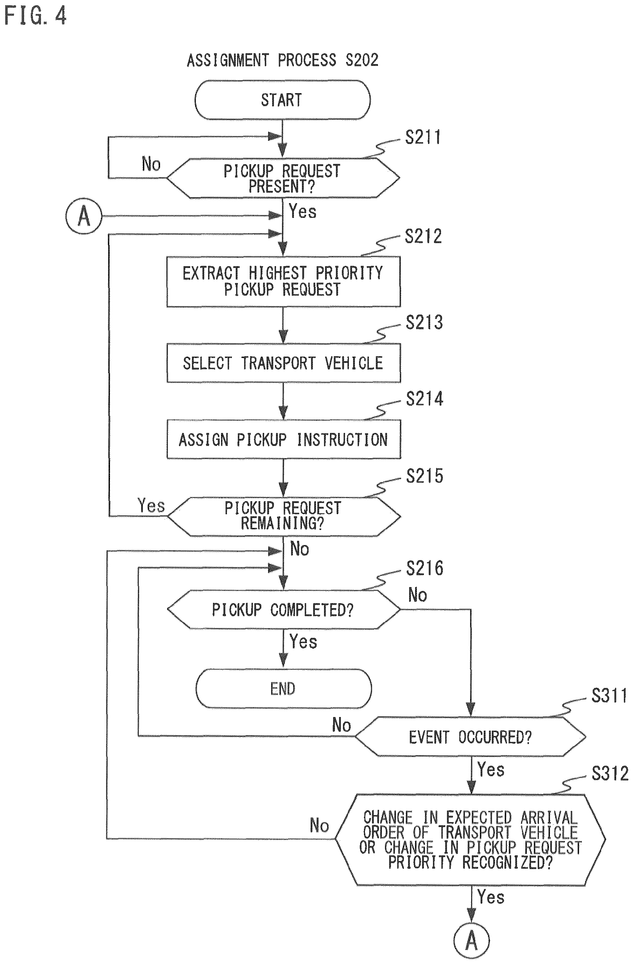

Fig. 4 is a diagram showing an example of an operation flow related to the above assignment process (Step S202). In the assignment process of Step S202, the assignment processor 116 determines whether or not there are pickup requests, as shown in Fig. 4 (Step S211). That is to say, the assignment processor 116 determines, by the process of Step S201 described above, whether or not a transport instruction (pickup requests) has been received from the host controller 150. If it is determined that there is no pickup request (Step S211: No), the assignment processor 116 repeats the process of Step S211.

If it is determined that there are pickup requests (Step S211: Yes), the assignment processor 116 extracts a pickup request having the highest priority from the plurality of pickup requests (Step S212). This priority is a degree to which how much the transport of the article 2 needing a prompt transport should be prioritized over other articles, for example, and it is included in a pickup request (a transport instruction) and so forth transmitted from the host controller 150 to be notified to the controller 110. Next, the assignment processor 116 selects, from the plurality of transport vehicles V, a transport vehicle V which is expected to arrive earliest at the pickup point of the high-priority pickup request (Step S213).

In step S213, the assignment processor 116 first selects any one of the plurality of transport vehicles V, and transmits to the schedule creator 117 of the controller 110 information indicating the correspondence relationship between the transport vehicle V and the pickup instruction. On the basis of the correspondence relationship between the transport vehicle V selected by the assignment processor 116 and the pickup instruction, the schedule creator 117 makes reference to the information stored in the layout information table 123 and creates a transport schedule for the transport vehicle V to be transmitted to the assignment processor 116. If the assignment processor 116 finds that the transmitted transport schedule is suitable (yields the earliest arrival), the assignment processor 116 selects the transport vehicle V and transmits the transport schedule to the data transmitter/receiver 111 and the schedule manager 115.

If the assignment processor 116 finds that the transport schedule created by the schedule creator 117 is not suitable, the assignment processor 116 instructs the schedule creator 117 to create a transport schedule different from that transport schedule. In this manner, the process of creating a transport schedule is repeated in the schedule creator 117 until the assignment processor 116 finds that the created transport schedule is a suitable transport schedule.

In Step S213, the assignment processor 116 is not limited to selecting a transport vehicle V expected to arrive earliest at the pickup point of the high-priority pickup request. For example, the assignment processor 116 may select a transport vehicle V expected to arrive second or third at the pickup point. That is to say, the assignment processor 116 may exclude the transport vehicle V expected to arrive earliest at the pickup point, when selecting a transport vehicle V.

Next, the assignment processor 116 assigns a pickup instruction to the selected transport vehicle V so as to execute the high-priority pickup request (Step S214). Then, the assignment processor 116 determines whether or not any pickup request still remains (Step S215). If it is determined that there is a remaining pickup request (Step S215: Yes), the process returns to Step S212 and the processing described above is repeated. If it is determined that there is no remaining pickup request (Step S215: No), the assignment processor 116 (the controller 110) determines whether or not the pickup of the article M has been completed by the previously assigned pickup request (Step S216).

If it is determined that the pickup of the article M has been completed (Step S216: Yes), the assignment processor 116 (the controller 110) ends the assignment process of Step S202. In Step S216, the completion of the pickup of the article M is determined by receiving a pickup completion report from the transport vehicle V, as shown in Step S206 of Fig. 3. As shown in Fig. 3, the controller 110 performs the processing for managing various resources such as the transport vehicles V and the stations ST until the transport vehicle V completes the pickup of the article M (Step S301).

That is to say, in Step S216 shown in Fig. 4, if it is determined that the pickup of the article M is not completed (Step S216: No), the controller 110 determines whether or not a specific event has occurred (Step S311). Examples of the specific event include: a pickup request having a priority higher than that of the pickup request in any of the previously assigned pickup instructions newly emerging; the preceding transport vehicle V among the plurality of transport vehicles V having passed through the merging part PA or the branching part PB provided on the track T; a delay by a predetermined amount of time having been determined in any of the transport vehicles V traveling toward the pickup points ST; and a predetermined amount of time having elapsed when the plurality of transport vehicles V are traveling toward the pickup points ST.

If it is determined that no event has occurred (Step S311: No), the process returns to Step S216. If it is determined that an event has occurred (Step S311: Yes), the controller 110 determines whether or not a change in the expected arrival order of the plurality of transport vehicles V traveling toward the pickup points ST or a change in the priorities of the pickup requests is recognized (Step S312). If it is determined that a change in the expected arrival order of the plurality of transport vehicles V traveling toward the pickup points ST or a change in the priorities of the pickup requests is not recognized (Step S312: No), the process returns to Step S216. If it is determined that a change in the expected arrival order of the plurality of transport vehicles V traveling toward the pickup points ST or a change in the priorities of the pickup requests is recognized (Step S312: Yes), the process returns to Step S212, and the controller 110 cancels the pickup instruction previously assigned to each of the plurality of transport vehicles V, and assigns a pickup instruction thereto again by the assignment process (the processing in and after Step S212).

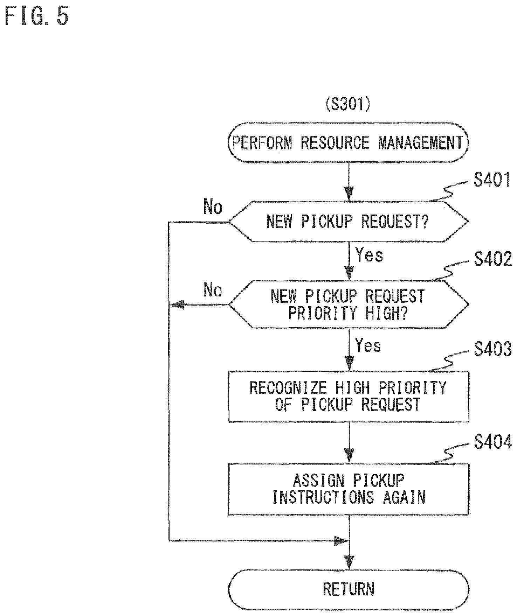

Hereunder, specific examples of the specific event shown in Step S311 and the process of Step S312 in the event (that is, the resource management of Step S301 shown in Fig. 3) will be described. In Fig. 5 and subsequent figures, two transport vehicles V are taken as an example for the description, and the same holds true for three or more transport vehicles V.

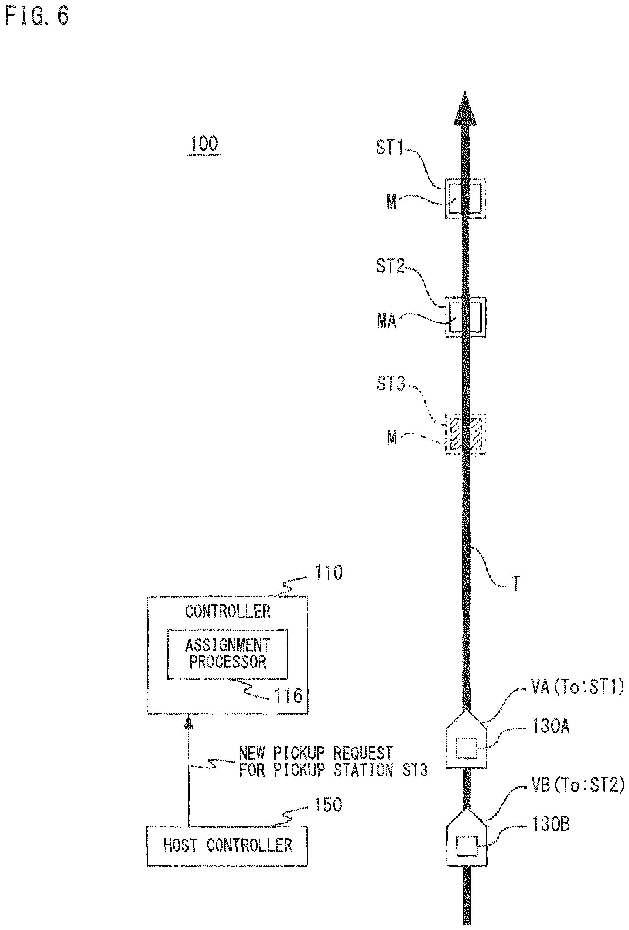

Fig. 5 is a diagram showing an example of an operation flow in assigning pickup instructions again. Fig. 6 to Fig. 8 show an example of the operation of the transport vehicles V corresponding to the operation flow shown in Fig 5. In the description of this operation flow, reference will be made to Fig. 1 to Fig. 4 where appropriate. The example shown in Fig. 5 is a case where, as a specific event, a new pickup request with a priority higher than that of the pickup request in any of the previously assigned pickup instructions newly emerges. The example shown in Fig. 5 shows an example of a state where a plurality of pickup instructions have already been assigned to the same number of transport vehicles V, and there is no transport vehicle V having no pickup instruction assigned thereto.

As shown in Fig. 6, in accordance with the pickup instructions assigned already, a pickup point ST1 is assigned to a transport vehicle VA, and a pickup point ST2 is assigned to a transport vehicle VB. The transport vehicle VA is traveling on the track T and is preceding the transport vehicle VB. The pickup point ST1 is arranged at a position farther than the pickup point ST2 (on the downstream side of the track T).

As shown in Fig. 5, the assignment processor 116 determines whether or not a new pickup point ST has emerged (Step S401). As described above, in the case where a transport instruction related to the addition of a new pickup point ST3 is received from the host controller 150 as shown in Fig. 6, the transport instruction manager 113 of the controller 110 transmits a transport instruction to the assignment processor 116. The priority of the pickup request is set high for the pickup point ST3 because an article MA the transport of which is prioritized is placed thereat.

In Step S401, if it is determined that a new pickup point ST3 has emerged (Step S401: Yes), the assignment processor 116 determines whether the new pickup point ST3 is of a pickup request of a priority higher than those of the other pickup points ST1, ST2 (Step S402). When transmitting the new transport instruction, the host controller 150 includes, in the content of the new transport instruction, information indicating that the priority of the pickup request is high for the article MA at the pickup point ST3. In Step S402, by receiving the transport instruction, the assignment processor 116 can make reference to this information and acquire that the new pickup request has a priority higher than those of the other pickup requests.

Fig. 6 shows that the new pickup point ST3 has emerged, and the priority of the pickup request thereof is higher than that of either of the pickup point ST1 already assigned to the transport vehicle VA or the pickup point ST2 already assigned to the transport vehicle VB.

If it is determined in Step S402 that the priority of the pickup request at the new pickup point ST3 is high (Step S402: Yes), the assignment processor 116 recognizes the priorities of the pickup requests as having changed (Step S403). Then, the assignment processor 116 cancels the pickup instructions previously assigned to the plurality of transport vehicles V traveling toward pickup points ST, and assigns pickup instructions thereto again by the assignment process (Step S202) (Step S404). That is to say, the processes of Step S212 and subsequent steps are performed, following "Yes" in Step S312 of Fig. 4.

Fig. 6 shows a state where the high-priority pickup point ST3 is positioned on the near side (the upstream side) of the pickup points ST1, ST2 in the traveling direction of the transport vehicles V, and the transport vehicles VA, VB are traveling toward the pickup point ST3. The assignment processor 116 extracts the high-priority pickup request (the pickup point ST3) according to Step S212 of Fig. 4. Next, the assignment processor 116 selects the transport vehicle VB according to Step S213 of Fig. 4. For example, if the pickup point ST3 is assigned to the transport vehicle VA, the transport vehicle VB needs to stand by on the track T while the transport vehicle VA performs its pickup operation at the pickup point ST3, and therefore, the assignment processor 116 selects the transport vehicle VB as the best suited transport vehicle V for traveling toward the pickup point ST3. That is to say, the assignment processor 116 selects the transport vehicle VB which arrives second at the pickup point ST3, taking the efficiency of the pickup operation at the pickup points ST1, ST2 into consideration.

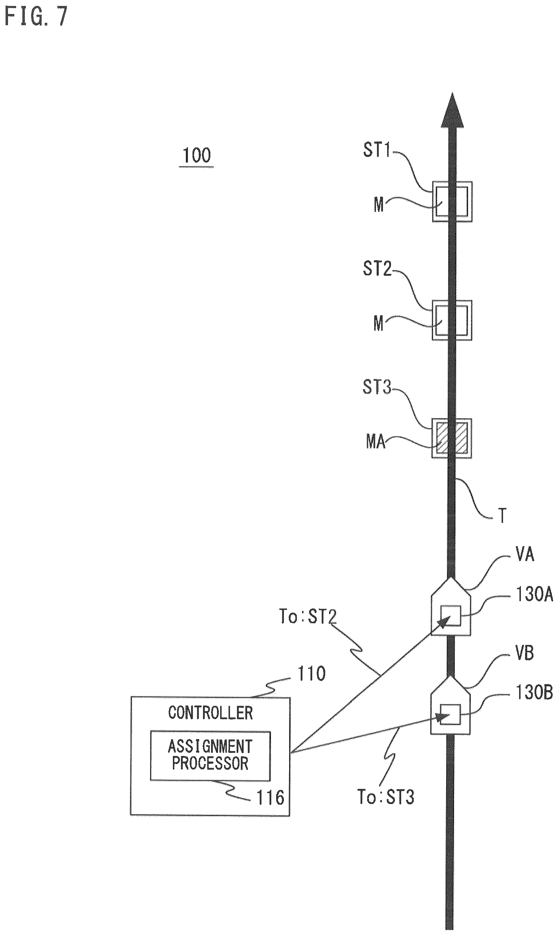

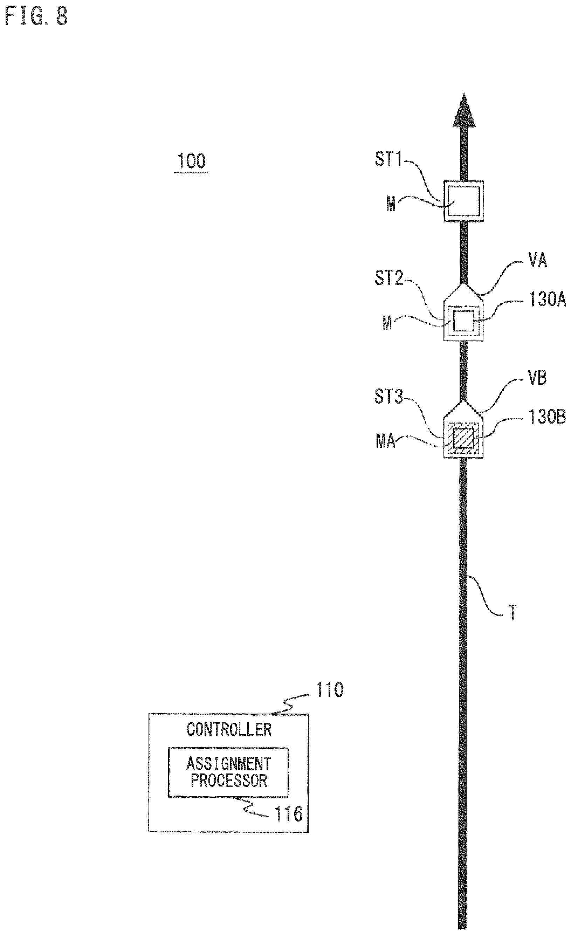

Then, the assignment processor 116 again assigns a pickup instruction which instructs the transport vehicle VB to perform a pickup at the pickup point ST3, according to Step S213 of Fig. 4. The assignment processor 116 assigns the transport vehicle VA with a pickup instruction for the pickup point ST2. A pickup instruction for the pickup point ST1 may be assigned to the transport vehicle VA. When the re-assigned pickup instructions have been transmitted to the traveling transport vehicles VA, VB as shown in Fig. 7, as shown in Fig. 8, the transport vehicle VA travels toward the pickup point ST2 and performs an operation to pick up the article M after arriving at the pickup point ST2, and the transport vehicle VB travels toward the pickup point ST3 and performs an operation to pick up the article MA after arriving at the pickup point ST3.

In Step S401, if it is determined that a new pickup point ST has not emerged (Step S401: No), the current state is maintained and the process ends. Also, if it is not determined in Step S402 that the priority of the new pickup point ST is high (Step S402: No), the current state is maintained and the process ends. In this manner, even in the case where a new pickup point ST emerges, assignment of pickup instructions is not performed if the priority thereof is not high, and as a result, the processing load on the assignment processor 116 can be reduced. Even if it is not determined in Step S402 that the priority of the new pickup point ST is high (Step S402: No), the assignment processor 116 may perform assignment (Step S404) of pickup instructions again by the assignment process (Step S202).

As described above, according to the example shown in Fig. 5, if a new pickup request of a high pickup request priority emerges (if the status of pickup requests changes) after pickup instructions have been assigned to the plurality of transport vehicle V, pickup instructions are assigned again to the plurality of transport vehicles V. Therefore, it is possible to avoid a delay in the transport of the article MA which needs to be prioritized.

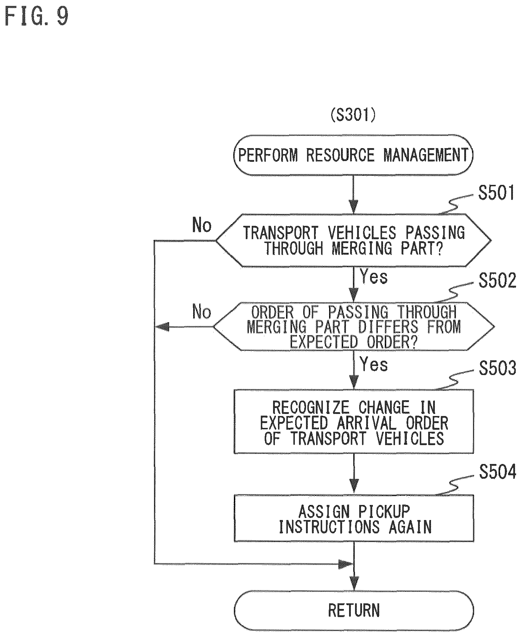

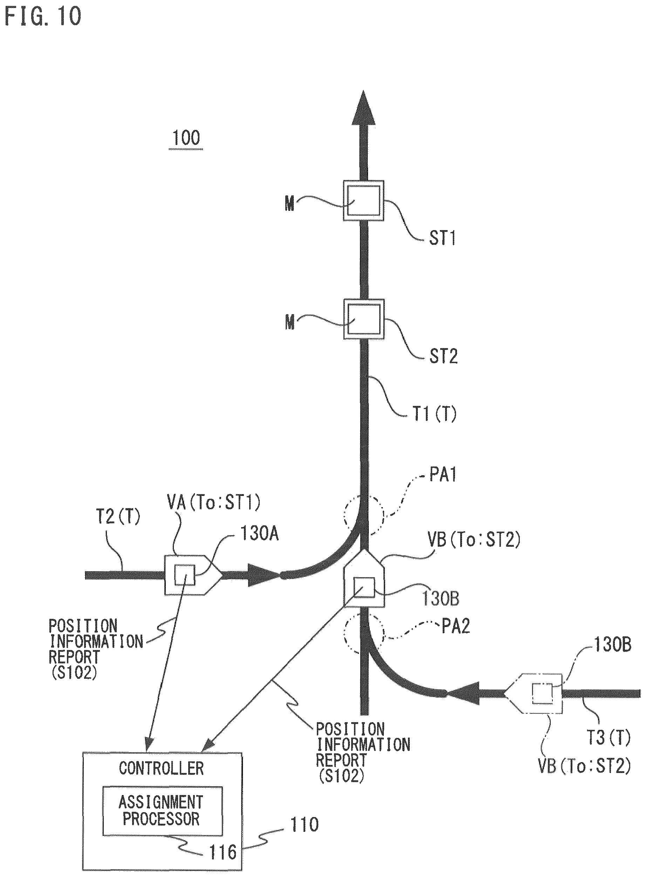

Fig. 9 is a diagram showing another example of the operation flow in assigning pickup instructions again. Fig. 10 to Fig. 12 show an example of the operation of the transport vehicles V corresponding to the operation flow shown in Fig 9. In the description of this operation flow, reference will be made to Fig. 1 to Fig. 4 where appropriate. The example shown in Fig. 9 is a case where, as a specific event, the preceding transport vehicle V among the plurality of transport vehicles V passes through the merging part PA. In Fig. 10, there is described an example in which the pickup points ST1, ST2 are arranged along a main track T1 of the track, and there are a merging part PA1 where a branch track T2 of the track merges into the main track T1 and a merging part PA2 where a branch track T3 of the main track merges into the main track T1. When the transport vehicle VA traveled on the branch track T2 and the transport vehicle VB traveled on the branch track T3, the transport vehicle VA would be expected to pass through the merging part PA1 before the transport vehicle VB would. Accordingly, at this point in time, the pickup point ST1 positioned farther than the pickup point ST2 was assigned to the transport vehicle VA, which was expected to pass through the merging part PA1 first. The pickup point ST2 was assigned to the transport vehicle VB.

As shown in Fig. 9, the assignment processor 116 determines whether or not at least one of the plurality of transport vehicles V traveling toward the pickup points ST passes through the merging part PA1 provided on the track T (Step S501). As described above, the controller 110 updates the latest position information of the plurality of transport vehicles V at the predetermined cycle. In the process of Step S501, the assignment processor 116 makes reference to the latest position information of the transport vehicles V and determines the transport vehicle V which passes through the merging part PA1 earliest. When performing this determination, the assignment processor 116 may make reference to the position information while the transport vehicle V is passing through the merging portion PA1 or after it has passed therethrough, or may make reference to the position information before the transport vehicle V passes therethrough. The assignment processor 116 may make reference to the information of the transport vehicle V which has been given a permission to pass through the merging part PA1.

In Fig. 10, the transport vehicle VA is traveling at a reduced speed due to a congestion or the like, and is traveling on the branch track T2 on the near side of the merging part PA1. Meanwhile, the transport vehicle VB is already traveling on the main track T1, coming from the branch track T3 via the merging part PA2, and is approaching the merging part PA1. Therefore, according to the position information at this time, the assignment processor 116 determines that the transport vehicle VB would pass through the merging part PA1 earliest (or before the transport vehicle VA would). There may be a case where the transport vehicle VB has acquired a permission to pass through the merging part PA1 before the transport vehicle VA. In such a case, the assignment processor 116 may determine that the transport vehicle VB having acquired the passage permission would pass through the merging part PA1 before the transport vehicle VA would.

If the assignment processor 116 determines that at least one of the plurality of transport vehicles V traveling toward the pickup points ST would pass through the merging part PA (Step S501: Yes), the assignment processor 116 determines whether or not the order of the plurality of transport vehicles V passing through the merging part PA differs from the order thereof passing through the merging part PA expected from the previously assigned pickup instructions (Step S502). As mentioned above, when the transport vehicle VA traveled on the branch track T2 and the transport vehicle VB traveled on the branch track T3, the transport vehicle VA would be expected to pass through the merging part PA1 before the transport vehicle VB would. However, in Step S501, it is determined that the transport vehicle VB would pass through the merging part PA1 first. Therefore, the assignment processor 116 determines that the order of the transport vehicles V passing through the merging part PA1 differs from the expected order of the transport vehicles V passing through the merging part PA1.

If it is determined that the order of the plurality of transport vehicles V passing through the merging part PA differs from the expected order thereof passing through the merging part PA1 (Step S502: Yes), the assignment processor 116 recognizes that the expected order of arrival has changed in the plurality of transport vehicles V traveling toward the pickup points ST in accordance with the pickup instructions (Step S503). That is to say, at the timing when at least one of the plurality of transport vehicles V passes through the merging part PA1, the assignment processor 116 recognizes that the expected arrival order has changed. Then, the assignment processor 116 cancels the pickup instructions previously assigned to the plurality of transport vehicles V traveling toward the pickup points ST, and assigns pickup instructions thereto again by the assignment process (Step S202) (Step S504). That is to say, the processes of Step S212 and subsequent steps are performed, following "Yes" in Step S312 of Fig. 4.

In Fig. 10, since the transport vehicle VA was expected to pass through the merging part PA1 before the transport vehicle VB, the pickup point ST1 positioned farther than the pickup point ST2 on the main track T1 has already been assigned to the transport vehicle VA, and the pickup point ST2 on the near side (the upstream side) of the pickup point ST1 has already been assigned to the transport vehicle VB. In Step S504, the assignment processor 116 follows the processing from Steps S212 to Step S215 of Fig. 4 to select the transport vehicle VB for the pickup point ST1 and the transport vehicle VA for the pickup point ST2, and then assigns a pickup instruction again to each of the transport vehicle VA and the transport vehicle VB.

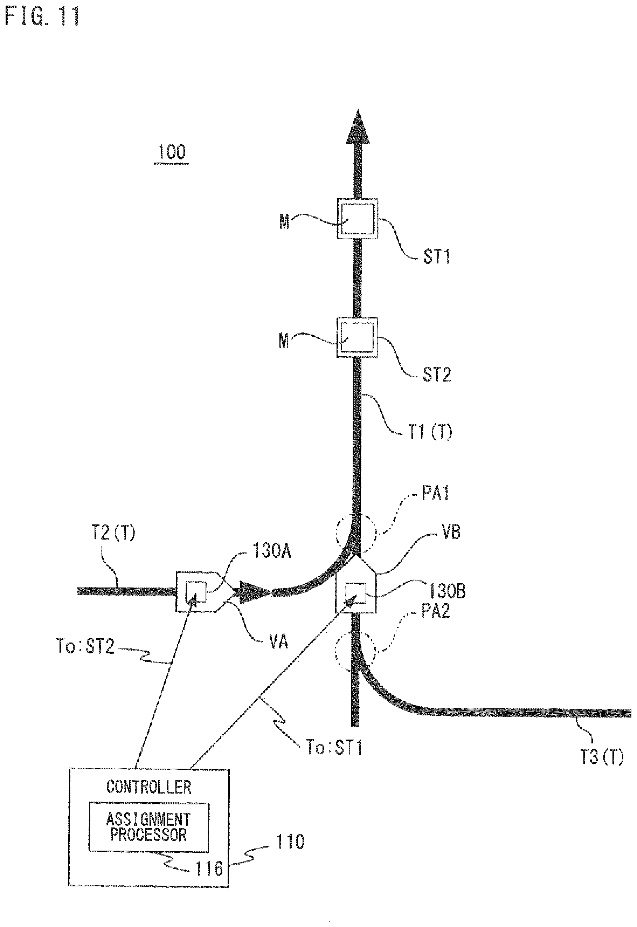

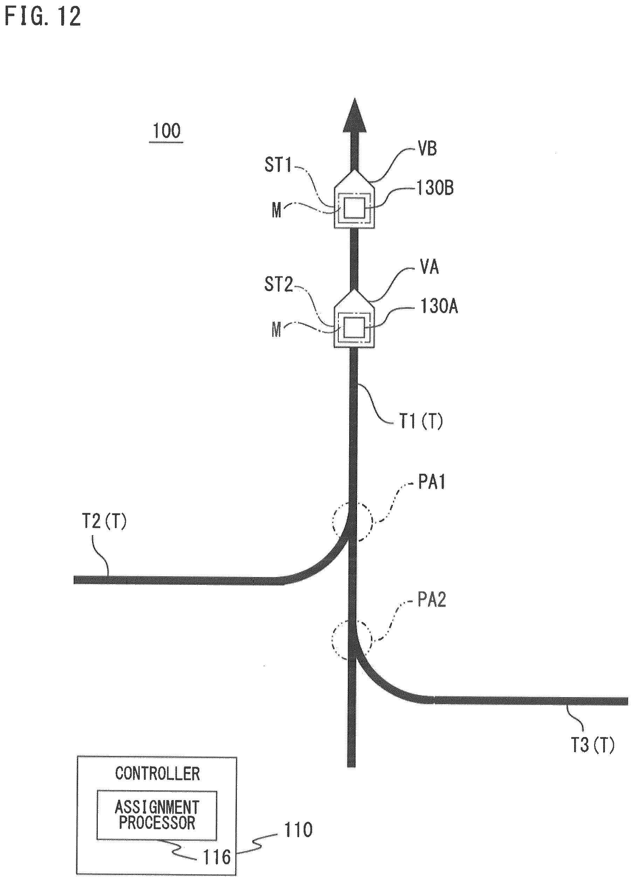

When the re-assigned pickup instructions have been transmitted to the traveling transport vehicles VA, VB as shown in Fig. 11, as shown in Fig. 12, the transport vehicle VB, which has passed through the merging part PA1 first, travels toward the pickup point ST1, and after arriving at the pickup point ST1, performs the operation of picking up the article M. Having passed through the merging part PA1 after the transport vehicle VB had passed therethrough, the transport vehicle VA travels toward the pickup point ST2, and after arriving at the pickup point ST2, performs the operation of picking up the article M.

If it is determined in Step S501 that no transport vehicle V has passed through the merging part PA1 (Step S501: No), the current state is maintained and the process ends. If it is determined in Step S502 that the order of the plurality of transport vehicles V passing through the merging part PA matches the expected order thereof passing through the merging part PA1 (Step S502: No), also the current state is maintained and the process ends. As described above, when the transport vehicles V pass through the merging part PA1, if the order thereof matches the expected order thereof passing through the merging part PA1, pickup instructions are not assigned again, and therefore, the processing load on the assignment processor 116 can be reduced.

As described above, according to the example shown in Fig. 9, since pickup instructions are assigned again in accordance with the order of the transport vehicles V passing through the merging part PA1, it is possible to efficiently perform the operation of picking up the article M at the pickup instructions ST1, ST2.

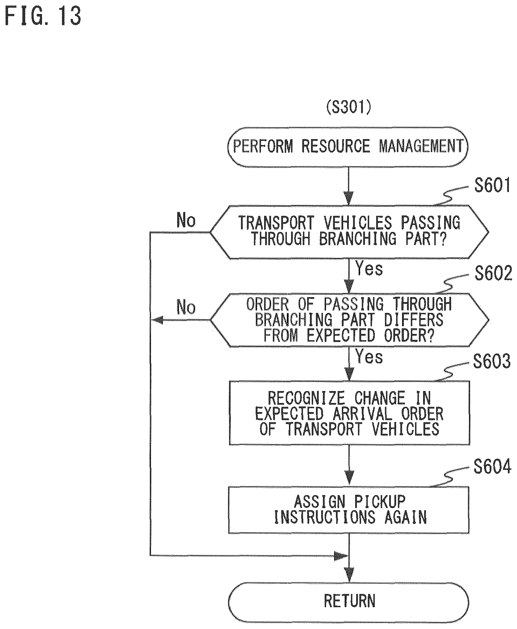

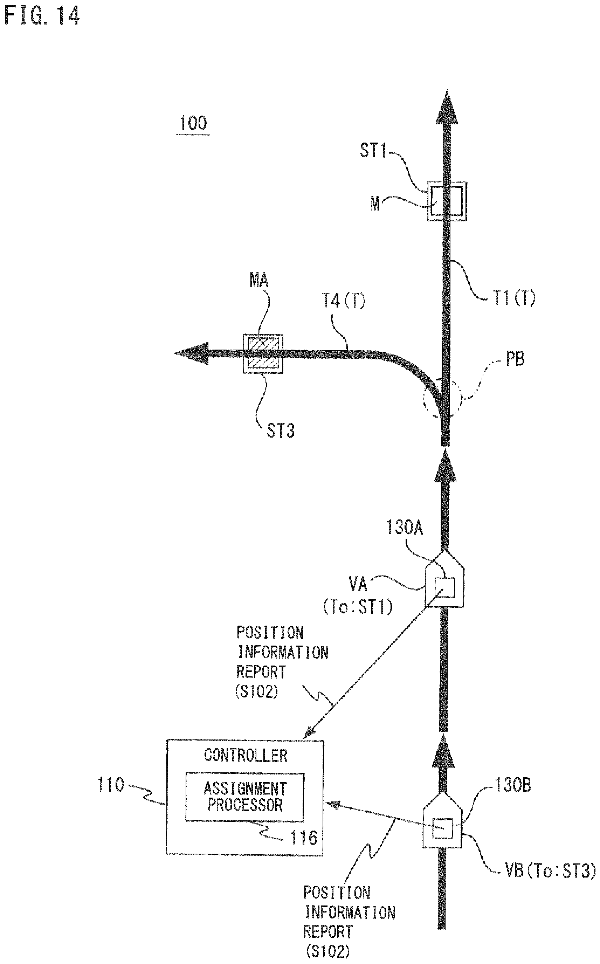

Fig. 13 is a diagram showing another example of the operation flow in assigning pickup instructions again. Fig. 14 to Fig. 16 show an example of the operation of the transport vehicles V corresponding to the operation flow shown in Fig 13. In the description of this operation flow, reference will be made to Fig. 1 to Fig. 4 where appropriate. The example shown in Fig. 13 is a case where, as a specific event, the preceding transport vehicle V among the plurality of transport vehicles V passes through the branching part PB. In Fig. 14, an example will be described in which the pickup point ST1 is arranged on the main track T1 of the track, and the pickup point ST3 is arranged on a branch track T4 which branches off from the main track T1 at the branching part PB. In this example, the article MA at the pickup point ST3 is of a priority higher than that of the article M at the pickup point ST1. When the pickup instructions were assigned previously, the transport vehicle VB was traveling on the main track T1 and was preceding the transport vehicle VA, and the transport vehicle VB was expected to pass through the branching part PB before the transport vehicle VA. Accordingly, at this point, the pickup point ST3 was assigned to the transport vehicle VB, which was expected to pass through the branching part PB first, and the pickup point ST1 was assigned to the transport vehicle VA.

As shown in Fig. 13, the assignment processor 116 determines whether or not at least one of the plurality of transport vehicles V traveling toward the pickup points ST passes through the branching part PB provided on the track T (Step S601). As described above, the controller 110 updates the latest position information of the plurality of transport vehicles V at the predetermined cycle. In the process of Step S601, the assignment processor 116 makes reference to the latest position information of the transport vehicles V and determines the transport vehicle V which passes through the branching part PB earliest. If there is no branching part or merging part on the upstream side of the branching part PB on the main track T1, the order of the transport vehicles V traveling on the main track T1 does not change. The assignment processor 116 can promptly grasp the order of the plurality of transport vehicles V passing through the branching part PB by acquiring the position information of the plurality of transport vehicles V traveling on the main track T1 as described above. The assignment processor 116 may make reference to the information of the transport vehicle V which has been given a permission to pass through the branching part PB.

In Fig. 14, the transport vehicle VB is traveling on the main track T1 and is preceding the transport vehicle VA. Therefore, according to the position information at this time, the assignment processor 116 determines that the transport vehicle VA would pass through the branching part PB earliest (or before the transport vehicle VB would). There may be a case where the transport vehicle VA has acquired a permission to pass through the branching part PB before the transport vehicle VB. In such a case, the assignment processor 116 may determine that the transport vehicle VA having acquired the passage permission would pass through the branching part PB before the transport vehicle VB would.

If the assignment processor 116 determines that at least one of the plurality of transport vehicles V traveling toward the pickup points ST would pass through the branching part PB (Step S601: Yes), the assignment processor 116 determines whether or not the order of the plurality of transport vehicles V passing through the branching part PB differs from the order thereof passing through the branching part PB expected from the previously assigned pickup instructions (Step S602). As described above, when the pickup instructions were assigned previously, the transport vehicle VB was traveling on the main track T1 and was preceding the transport vehicle VA, and the transport vehicle VB was expected to pass through the branching part PB before the transport vehicle VA. However, in Step S601, it is determined that the transport vehicle VA would pass through the branching part PB first. Therefore, the assignment processor 116 determines that the order of the transport vehicles V passing through the branching part PB differs from the expected order of the transport vehicles V passing through the branching part PB.

If it is determined that the order of the plurality of transport vehicles V passing through the branching part PB differs from the expected order thereof passing through the branching part PB (Step S602: Yes), The assignment processor 116 recognizes that the expected order of arrival has changed in the plurality of transport vehicles V traveling toward the pickup points ST in accordance with the pickup instructions (Step S603). That is to say, at the timing when or before at least one of the plurality of transport vehicles V passes through the branching part PB, the assignment processor 116 recognizes that the expected arrival order has changed. Then, the assignment processor 116 cancels the pickup instructions previously assigned to the plurality of transport vehicles V traveling toward the pickup points ST, and assigns pickup instructions thereto again by the assignment process (Step S202) (Step S604). That is to say, the processes of Step S212 and subsequent steps are performed, following "Yes" in Step S312 of Fig. 4.

In Fig. 14, since the transport vehicle VB was expected to pass through the branching part PB before the transport vehicle VA, the pickup point ST3 on the branch track T4 (the high-priority article MA) has already been assigned to the transport vehicle VB. In Step S604, the assignment processor 116 follows the processing from Steps S212 to Step S215 of Fig. 4 to select the transport vehicle VA for the pickup point ST3 and the transport vehicle VB for the pickup point ST1, and then assigns a pickup instruction again to each of the transport vehicle VA and the transport vehicle VB.

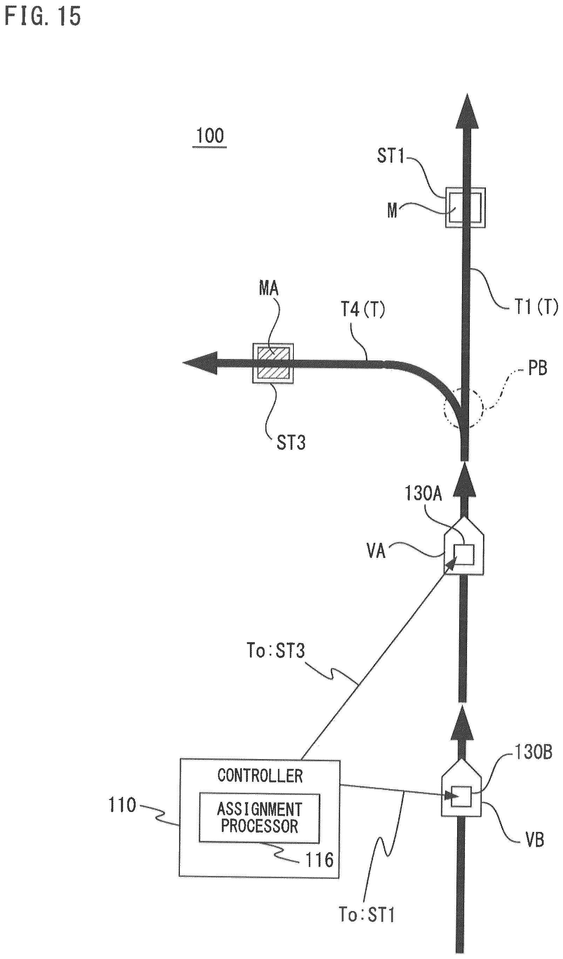

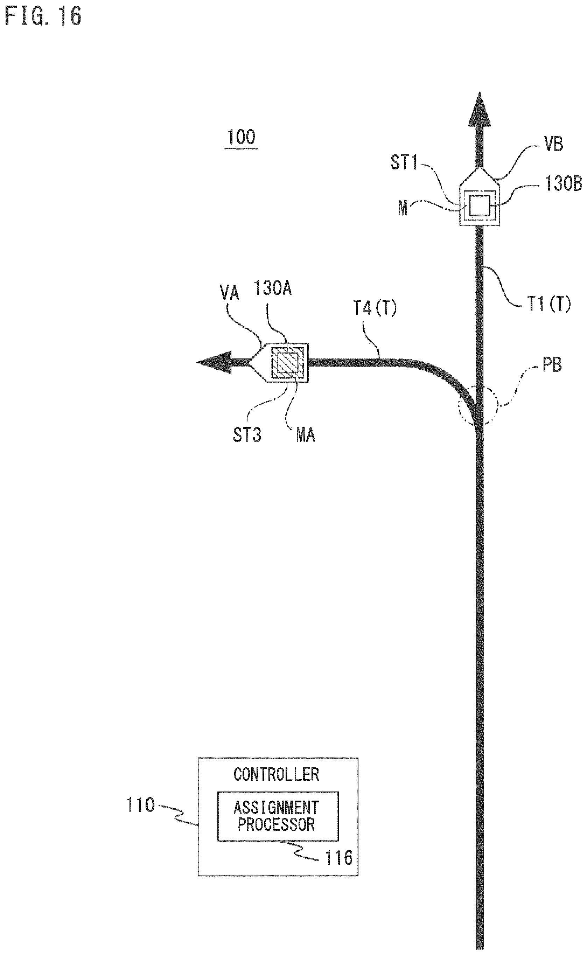

When the re-assigned pickup instructions have been transmitted to the traveling transport vehicles VA, VB as shown in Fig. 15, as shown in Fig. 16, the transport vehicle VA, which has passed through the branching part PB first, travels on the branch track T4 toward the pickup point ST3, and after arriving at the pickup point ST3, performs the operation of picking up the article MA. Having passed through the branching part PB after the transport vehicle VA had passed therethrough, the transport vehicle VB travels on the main track T1 toward the pickup point ST1, and after arriving at the pickup point ST1, performs the operation of picking up the article M. In this way, it is possible to complete the operation of picking up the high-priority article MA promptly and perform the transport to the unloading point promptly.

If it is determined in Step S601 that no transport vehicle V has passed through the branching part PB (Step S601: No), the current state is maintained and the process ends. If it is determined in Step S602 that the order of the plurality of transport vehicles V passing through the branching part PB matches the expected order thereof passing through the branching part PB (Step S602: No), also the current state is maintained and the process ends. As described above, when the transport vehicles V pass through the branching part PB, if the order thereof matches the expected order thereof passing through the branching part PB, pickup instructions are not assigned again, and therefore, the processing load on the assignment processor 116 can be reduced.

As described above, according to the example shown in Fig. 13, pickup instructions are assigned again on the basis of the order of the transport vehicles V passing through the branching part PB so as to perform a prompt pickup of the article MA of the high-priority pickup request, and therefore, it is possible to avoid a delay in the transport of the article MA which needs to be prioritized.

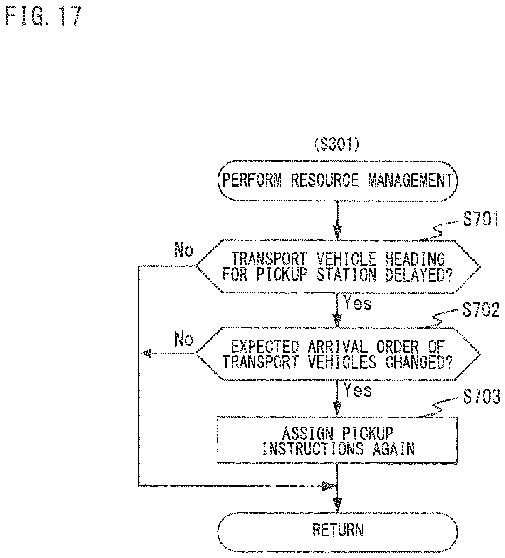

Fig. 17 is a diagram showing another example of the operation flow in assigning pickup instructions again. In the description of this operation flow, reference will be made to Fig. 1 to Fig. 4 where appropriate. The example shown in Fig. 17 is a case where, as a specific event, a delay is determined in any one of the transport vehicles V traveling toward the pickup points ST. In such a case, congestion, malfunction, or the like may be considered as a possible cause of the delay in any one of the transport vehicles V traveling toward the pickup points ST.

As shown in Fig. 17, the assignment processor 116 determines whether or not a delay has occurred in any one of the transport vehicles V traveling toward the pickup points ST (Step S701). As described above, the controller 110 updates the latest position information of the plurality of transport vehicles V at the predetermined cycle. In the process of Step S701, the assignment processor 116 determines a delay of the transport vehicle V by making reference to the latest position information of the transport vehicle V.

Upon receiving a new position information report, the transport vehicle manager 112 of the controller 110 updates the information stored in the transport vehicle information table 121 with the position information of the transport vehicle V reported in the position information report. The schedule manager 115 makes reference to the position information of the transport vehicle V stored in the transport vehicle information table 121 and the transport schedule of the transport vehicle V stored in the schedule table 124, and if the transport vehicle V traveling toward the pickup point ST is delayed by more than a specific amount of time, the schedule manager 115 notifies the assignment processor 116 to that effect. The specific amount of time may be preliminarily set by an administrator or the like, or may be automatically set according to the target article M of the pickup operation. Upon having been notified by the schedule manager 115, the assignment processor 116 determines the delay of the transport vehicle V.

If it is determined that any one of the transport vehicles V traveling toward the pickup point ST is delayed (Step S701: Yes), the assignment processor 116 determines whether or not the expected order of arrival has changed in the plurality of transport vehicles V traveling toward the pickup points ST in accordance with the pickup instructions (Step S702). That is to say, the assignment processor 116 determines whether or not the expected arrival order has changed, at the timing when any of the plurality of transport vehicles V delays.

If it is determined that the expected arrival order has changed in the plurality of transport vehicles V (Step S702: Yes), the assignment processor 116 recognizes the change in the expected arrival order, cancels the pickup instructions previously assigned to the plurality of transport vehicles V traveling toward the pickup points ST, and assigns pickup instructions thereto again by the assignment process (Step S202) (Step S703). That is to say, the processes of Step S212 and subsequent steps are performed, following "Yes" in Step S312 of Fig. 4. In Step S703, the assignment processor 116 selects a transport vehicle V for the pickup point ST according to Step S212 to Step S215 of Fig. 4, and assigns a pickup instruction again to each of the plurality of transport vehicles V.

When the re-assigned pickup instructions have been transmitted to the transport vehicles V, each transport vehicle V travels on the track T toward the instructed pickup point ST, and after arriving at the pickup point ST, performs the operation of picking up the article M. If it is determined that none of the transport vehicles V traveling toward the pickup points ST is delayed (Step S701: No), the current state is maintained and the process ends. If it is determined that the expected arrival order of the plurality of transport vehicles V has not changed (Step S702: No), also the current state is maintained and the process ends. As described above, if none of the transport vehicles V is delayed, and if the expected arrival order in the plurality of transport vehicles V has not changed, pickup instructions are not assigned again, and therefore the processing load on the assignment processor 116 can be reduced.

As described above, according to the example shown in Fig. 17, pickup instructions are assigned again if a delay occurs in any of the transport vehicles V, and therefore, it is possible to avoid a delay in the pickup operation (the transport) for any of the articles M, and articles M at the plurality of pickup points ST can be picked up efficiently.

In the example shown in Fig. 17, it is determined whether or not any of the transport vehicles V traveling toward the pickup points ST is delayed, however, this determination is not limited to this configuration, and it may be determined whether or not a specific transport vehicle V is delayed. For example, it may be determined whether or not there is a delay in a transport vehicle V traveling toward a pickup point ST where an article of a high-priority pickup request is placed, and if the transport vehicle V is delayed, pickup instructions may be assigned again. With this configuration, it is possible to avoid a delay in the transport of the article which needs to be prioritized.

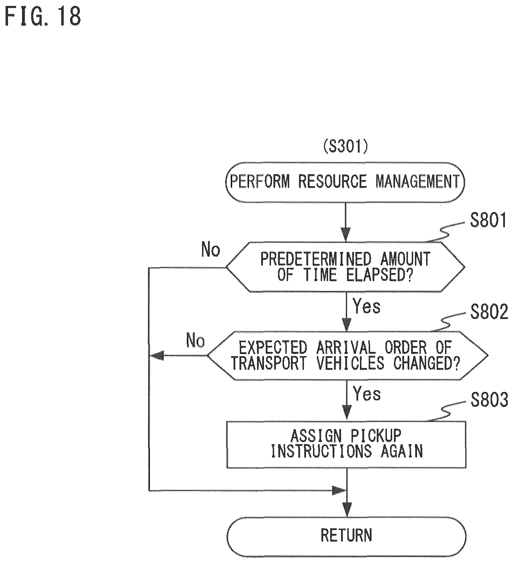

Fig. 18 is a diagram showing another example of the operation flow in assigning pickup instructions again. In the description of this operation flow, reference will be made to Fig. 1 to Fig. 4 where appropriate. The example shown in Fig. 18 is a case where, as a specific event, a predetermined amount of time has elapsed from a predetermined point in time. As the predetermined point in time, for example, an arbitrary point in time such as a point in time when pickup instructions are assigned again to the plurality of transport vehicles V, or a point in time when a determination in Step S801 described below is performed, can be applied. In the case where the point in time when the determination of Step S801 is performed is used as the predetermined point in time, the operation flow shown in Fig. 18 is performed at timings at predetermined time intervals (at a constant cycle).

As shown in Fig. 18, the assignment processor 116 determines whether or not a predetermined amount of time has elapsed when there are a plurality of transport vehicles V traveling toward pickup points ST (Step S801). The assignment processor 116 acquires the amount of time elapsed from the predetermined point in time, using a timer or the like (not shown in the drawings) included in the controller 110, and determines whether or not the predetermined amount of time has elapsed.

If it is determined that the predetermined amount of time has elapsed (Step S801: Yes), the assignment processor 116 determines whether or not the expected order of arrival has changed in the plurality of transport vehicles V traveling toward the pickup points ST in accordance with the pickup instructions (Step S802). In the process of Step S802, the assignment processor 116 determines the expected arrival time at the pickup point ST toward which each transport vehicle V is traveling, making reference to the latest position information of the plurality of transport vehicles V, and determines whether or not a change has occurred in the previously expected arrival order.

If it is determined that the expected arrival order has changed in the plurality of transport vehicles V (Step S802: Yes), the assignment processor 116 recognizes the change in the expected arrival order, cancels the pickup instructions previously assigned to the plurality of transport vehicles V traveling toward the pickup points ST, and assigns pickup instructions thereto again by the assignment process (Step S202) (Step S803). That is to say, the processes of Step S212 and subsequent steps are performed, following "Yes" in Step S312 of Fig. 4. In Step S803, the assignment processor 116 selects a transport vehicle V for the pickup point ST according to Step S212 to Step S215 of Fig. 4, and assigns a pickup instruction again to each of the plurality of transport vehicles V.

When the re-assigned pickup instructions have been transmitted to the transport vehicles V, each transport vehicle V travels on the track T toward the instructed pickup point ST, and after arriving at the pickup point ST, performs the operation of picking up the article M. If it is determined that the predetermined amount of time has not elapsed (Step S801: No), the current state is maintained and the process ends. If it is determined that the expected arrival order of the plurality of transport vehicles V has not changed (Step S802: No), also the current state is maintained and the process ends. As described above, if the predetermined amount of time has not elapsed and if the expected arrival order of the plurality of transport vehicles V has not changed, pickup instructions are not assigned again, and therefore the processing load on the assignment processor 116 can be reduced.

As described above, according to the example shown in Fig. 18, pickup instructions are assigned again if the predetermined amount of time has elapsed and the expected arrival time of the plurality of transport vehicles V has changed. Therefore, even in a case where a problem occurs in any of the plurality of transport vehicles V executing a plurality of pickup requests and that transport vehicle V becomes unable to perform the pickup operation, pickup instructions can be assigned again and the articles M at the plurality of pickup points ST can be picked up efficiently.

The operation flow shown in Fig. 18 may be executed in combination with any of the operation flows shown in Fig. 5, Fig. 9, Fig. 13, and Fig. 17. That is to say, the processing of Step S801 and thereafter for determining whether or not the predetermined amount of time has elapsed may be executed while executing the operation flow shown in Fig. 5, Fig. 9, Fig. 13, or Fig. 17. With this configuration, even in a case where: a new high-priority pickup request has emerged; the preceding transport vehicle V among the plurality of transport vehicles V has passed through the merging part PA or the branching part PB; a delay has been determined in a transport vehicle V; and despite the fact these events have occurred, the controller 110 have overlooked or have been unable to acquire the occurrence of the events, if Step S801 determines the predetermined amount of time as having elapsed, it is still possible to determine in Step S802 the change in the expected arrival order of the plurality of transport vehicles V and assign pickup instructions thereto again, which covers the overlooked event occurrences.

The embodiment of the present invention has been described above. However, the technical scope of the invention is not limited to the description of the above embodiment. It is also apparent to those skilled in the art that various modifications or improvements can be added to the above embodiment. The technical scope of the present invention also encompasses one or more of such modifications or improvements. The order of executing processes shown in the present embodiment can be realized in an arbitrary order unless an output of the previous processing is used in the following processing. Furthermore, while operations in the above embodiment have been described with expressions such as "first", "next", and "subsequently" for the sake of convenience, the operations need not always be implemented in that order.

In the embodiment described above, there is described the case where after assigning a pickup instruction to each of the plurality of transport vehicles V, there is no transport vehicle V under the management of the controller 110 to which a pickup instruction can be assigned, however, the invention is not limited to this mode. After assigning pickup instructions, there may be a transport vehicle V to which a pickup instruction can be assigned, under the management of the controller 110. For example, after assigning pickup instructions, a transport vehicle V which has completed transport of an article designated by another pickup instruction different from the pickup instruction and to which a new pickup instruction can be assigned, or a transport vehicle V which has moved from under the management of another controller to under the management of the controller 110 and to which a pickup instruction can be assigned, may be included in target transport vehicles V for the controller 110 to assign pickup instructions again.

The data transmitter/receiver 111 of the controller 110, the transport vehicle manager 112, the transport instruction manager 113, the layout manager 114, the schedule manager 115, the assignment processor 116, the schedule creator 117, the transport vehicle information table 121, the transport instruction information table 122, the layout information table 123, and the schedule table 124 mentioned above may be realized as a specific means in which software and hardware cooperate with each other, by reading a program on a computer. The contents of Japanese Patent Application No. 2018-076903 and all documents cited in the detailed description of the present invention are incorporated herein by reference to the extent permitted by law.

### Description of Reference Signs

- 100:: Transport vehicle system
- 110:: Controller
- 116:: Assignment processor
- 130,: 130A, 130B: In-vehicle controller
- 150:: Host controller
- M, MA:: Article
- PA, PA1, PA2:: Merging part
- PB:: Branching part
- ST, ST1, ST2, ST3:: Station (pickup point, unloading point)
- T:: Track
- T1:: Main track
- T2, T3, T4:: Branch track
- VA, VB:: Transport vehicle

## Claims

1. A transport vehicle system comprising:
a plurality of transport vehicles which travel on a track; and
a controller which performs an assignment process such that upon receiving a plurality of pickup requests, a transport vehicle expected to arrive sooner at a pickup point is selected from the transport vehicles in a descending order of priorities of the plurality of pickup requests, and a pickup instruction which instructs to travel to the pickup point arranged along the track and pick up an article at the pickup point is assigned to each one of the plurality of transport vehicles,
wherein the controller cancels the pickup instruction previously assigned to each of the plurality of transport vehicles and assigns a pickup instruction thereto again by the assignment process, when a change in an expected arrival order of the plurality of transport vehicles traveling toward the pickup points in accordance with the pickup instructions or a change in priorities of the pickup requests is recognized.

2. The transport vehicle system according to claim 1, wherein the controller determines whether or not the priorities of the pickup requests have changed, at a timing when a pickup request with a priority higher than that of the pickup request in any of the previously assigned pickup instructions newly emerges.

3. The transport vehicle system according to claim 1, wherein the track includes a merging part where a branch track merges into a main track,
wherein at least two of the pickup points are arranged on the main track ahead of the merging part, and
wherein the controller determines, at a timing when a preceding transport vehicle among the plurality of transport vehicles passes through the merging part, whether the expected arrival order of the plurality of transport vehicles has changed in a case where the actual passing order of the transport vehicles differs from that expected.

4. The transport vehicle system according to claim 1, wherein the track includes a branching part where a branch track branches off from a main track,
wherein the pickup point is arranged on the main track ahead of the branching part and on the branch track, and
wherein the controller determines, at a timing when a preceding transport vehicle among the plurality of transport vehicles passes through the branching part, whether the expected arrival order of the plurality of transport vehicles has changed in a case where the actual passing order of the transport vehicles differs from that expected.

5. The transport vehicle system according to claim 1, wherein the controller determines, at a timing of determining a delay of a predetermined amount of time in any of the transport vehicles traveling toward the pickup point, whether the expected arrival order of the plurality of transport vehicles has changed.

6. The transport vehicle system according to any one of claims 1 to 5,
wherein in a case where the plurality of transport vehicles are traveling toward the pickup points in accordance with the pickup instructions, the controller determines, at timings at predetermined time intervals, whether the expected arrival order of the plurality of transport vehicles has changed.

7. A transport vehicle control method for controlling a plurality of transport vehicles traveling on a track by means of a controller, the controller executing steps of:
performing an assignment process such that upon receiving a plurality of pickup requests, a transport vehicle expected to arrive sooner at a pickup point is selected from the plurality of transport vehicles in a descending order of priorities of the plurality of pickup requests, and a pickup instruction which instructs to travel to the pickup point arranged along the track and pick up an article at the pickup point is assigned to each one of the plurality of transport vehicles; and
canceling the pickup instruction previously assigned to each of the plurality of transport vehicles and assigning a pickup instruction thereto again by the assignment process, when a change in an expected arrival order of the plurality of transport vehicles traveling toward the pickup points in accordance with the pickup instructions or a change in priorities of the pickup requests is recognized.
